Europäisches Patentamt

(19) European Patent Office

Office européen des brevets

(11) Publication number: **0 063 170**

A2

(12) # EUROPEAN PATENT APPLICATION

(21) Application number: 81105096.2

(51) Int. Cl.³: **H 05 K 13/02**

(22) Date of filing: 01.07.81

(30) Priority: 21.04.81 US 252031

(43) Date of publication of application:
27.10.82 Bulletin 82/43

(84) Designated Contracting States:
DE FR GB IT

(71) Applicant: Rockwell International Corporation
2230 East Imperial Highway
El Segundo, California 90245(US)

(72) Inventor: Fowler, Charles Lee
621 Calle Miguel
San Clemente CA 92672(US)

(72) Inventor: Vasquez, Armando Carlos
24543 Los Alisos Blvd.
Laguna Hills CA 92653(US)

(72) Inventor: Pineda, Delfino (NMN) Gomez
Avenida Mariano Matamoros, 710
Colonia Por-Hagar Mexicali, B.C.(MX)

(74) Representative: Wagner, Karl H., Dipl.-Ing.
P.O. Box 22 02 46 Gewuerzmuehlstrasse 5
D-8000 München 22(DE)

(54) Pneumatic wire lifter and method.

(57) The invention is an air lifter for fine gage wires and is particularly adapted to cooperate with a wire bonder machine which intermittently advances lead frames along a pathway therethrough for MOS plastic packaging and bonds fine gage wires between terminals of a die or integrated chip, fixed to a pad carried by each lead frame, and a plurality of lead frame fingers of electrical connectors distributed about the pad periphery and spaced therefrom across a gap. It includes: means for developing gas pressure for gas blasts; pneumatic directing means disposed adjacent the pathway for the lead frames travelling through the machine at a location downstream of the wire bonding station for directing gas blasts at the wires to raise them above the pad with the directing means confining the gas blasts generally externally of and along the pad periphery in the gap region to bend the wires upwardly away from the pad, and timing means operating in synchronism with the advancing of the lead frames for initiating and terminating the gas blasts during the dwell intervals of the frames. The lifter, per se, avoids the synchronizing mechanism and includes: means for developing gas pressure for manually controlled gas blasts; pneumatic gas directing means for directing gas blasts at one or more wires from beneath to raise them intermediate their ends; and means for controlling the pressure and duration of said blasts with the directing means confining the gas discharge to the region of the one or more wires.

EP 0 063 170 A2

PNEUMATIC WIRE LIFTER AND METHOD

Field of the Invention

This invention is a novel structure and method for pneumatically lifting wires attached at both ends to bow them away from other objects, and more particularly relates to such a pneumatic air lifter applied to a wire bonder machine and operating in synchronism therewith.

Background of the Invention

Standard practice in the semiconductor industry is to attach the actual circuit, chip or die to the lead frames of a strip having various numbers of devices thereon. Connections are then made from each circuit to the terminals of its lead frame, using small gauge wire. This is accomplished by the use of wire bond machines which position and hold the lead frame while the work is performed and they then index the lead frame strip to the next position for similar work. These wire bond machines come from various manufacturers and in many different models, manual, semi-automatic, and fully automatic.

One of the most common problems with this operation is that the fine gauge wires often sag or touch other wires or parts of the lead frame or circuit which causes electrical shorts. It is common practice to rework these defects manually by lifting the wires using miniature probes, hooks, etc.

The purpose of this invention is to eliminate the costly rework of such defects by the use of a pneumatic wire lifter.

0063170

-2-

## Summary of the Invention

The invention comprises a structure and method for pneumatically lifting one or more wires intermediate their attached ends by developing gas pressure for controlled gas blasts, providing directing means extending adjacent to the one or more wires for directing the controlled air blasts against the one or more wires, and controlling the pressure and duration of the blasts to control the lifting without fracturing a wire. The invention is particularly adapted for combination with a wire bonder machine wherein the timing means operates in synchronism with the machine intermittent drive for advancing the lead frames thereby to initiate the gas blasts during the dwell intervals of the frames to lift the tiny gauge wires out of contact with other components for eliminating short circuits and the like.

## Brief Description of the Drawings

Figure 1 is a view in perspective of a wire bonder machine with the subject pneumatic wire lifter incorporated therewith;

Figure 2 is a top plan view taken along the pathway of the wire bonder machine to show details of the operation being carried out upstream of the pneumatic lifter station;

Figure 3 is a view in section through the air lifter nozzle and orifice structure showing the possible fine gauge wire positions prior to a gas blast;

Figure 4 shows the structure of Figure 3 following an air blast which bows the fine gauge wires upwardly;

Figure 5 is a partial view in perspective to show the lead frame gap and the anchoring of the opposite ends of a fine gauge wire on either sides of the gap;

Figure 6 is a view in perspective to illustrate the structure and operation of the lifter;

Figure 6a shows the solenoid valve microswitch follower in inoperative position relative to the timing means or cam;

Figure 6b shows the structure of Figure 6a, at a later time, with the microswitch actuated to operate the solenoid for the valve;

Figure 7 is a top plan view of principally a single lead frame with die in place on the pad thereof and a plurality of leads extending between the die and the connectors of the lead frame;

Figure 8 is a view in perspective of the manifold and nozzle showing the nozzle orifice of the pneumatic wire lifter;

Figure 9 is a similar structure showing a different type orifice;

Figure 10 is a view in plan of the structure of Figure 8;

Figure 11 is a view in section of the structure of Figure 10;

Figure 12 is a perspective view of a portion of the wire bonder machine showing the stylus and transducer in operative relation to the die terminals and the lead frame connectors with the stylus connecting gold wires therebetween.

Figure 13 is a detailed representation of the stylus with gold ball forming on the end of the gold wire to be bonded;

Figure 14 shows the stylus lowered against the work piece with the ball flattened on the end of the fine gauge wire;

Figure 15 shows the stylus being withdrawn after the flattened end of the ball bearing wire has been bonded to the work piece;

Figure 16 shows the succeeding step of movement of the stylus away from the die on the pad work piece and supplying wire for spanning the gap to the connector of the lead frame;

Figure 17 shows the stylus making contact with the fine wire on the connector surface;

Figure 18 shows the stylus mashing the heated wire against the connector surface in a downward movement breaking the wire by moving to the right;

Figure 19 shows the stylus and fine wire being withdrawn from the bonded position;

Figure 20 shows the re-forming of a ball on the wire for the next bonding operation, similar to Figure 13;

Figure 21 is a view in side elevation of the wire bond to the connector; and,

Figure 22 is a plan view of the wire bond of Figure 21.

Description of the Preferred Embodiment of the Invention

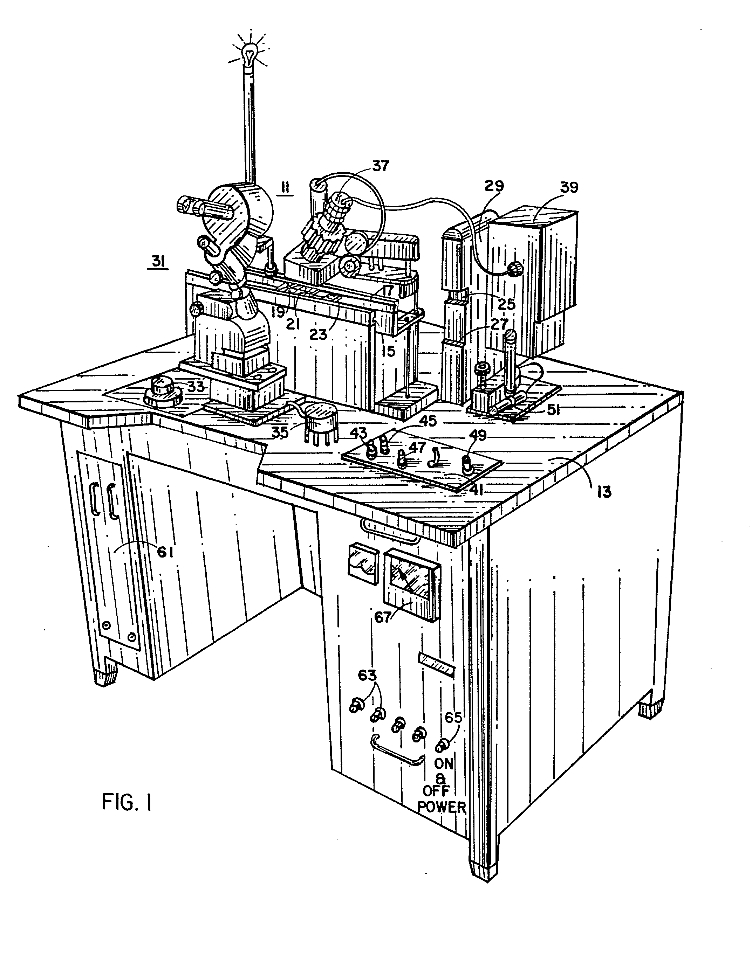

In Figure 1 there is shown in perspective a wire bonder machine generally at 11 supported by a bench top table-type support 13. A pair of spaced apart rails 15 and 17 define a pathway for the interconnected lead frames 19 and 21 being intermittently advanced therealong. Lead frame 19 is in position for clamping and bonding, i.e., the frame is indexed and rigidly held while the bonding head attaches the fine gauge wires; lead frame 21 is between the bonding station and the pneumatic lifter, generally shown at 23. The lead frame which would be over the air lifter in advance of lead frame 21 has been removed to show this station.

Usually, the feed for machine 11 comprises several integrally attached lead frames in strip form which advance through the machine 11 in units of five or six for convenient deposit in a carrier box (not shown) at the end of the pathway comprising rails 15 and 17 and normally detachably fitted to the machine by the slots 25 and 27 and the upright 29.

The machine of Figure 1 may be operated manually or in its automatic mode. Accordingly, the microscope 31 is provided for observation of the lead frames and tiny gauge wires while in the manual mode, and the manual controls 33 and 35 may be manipulated to control the bonding process.

For automatic mode, there is provided a TV camera 37, generally focused on the bonding station, and a TV control unit 39. The control panel 41 permits selection for automatic or manual by switch 43, provision for hold is available from switch 45 and the "on" position is had at switch 47 with "stop" being available from switch 49.

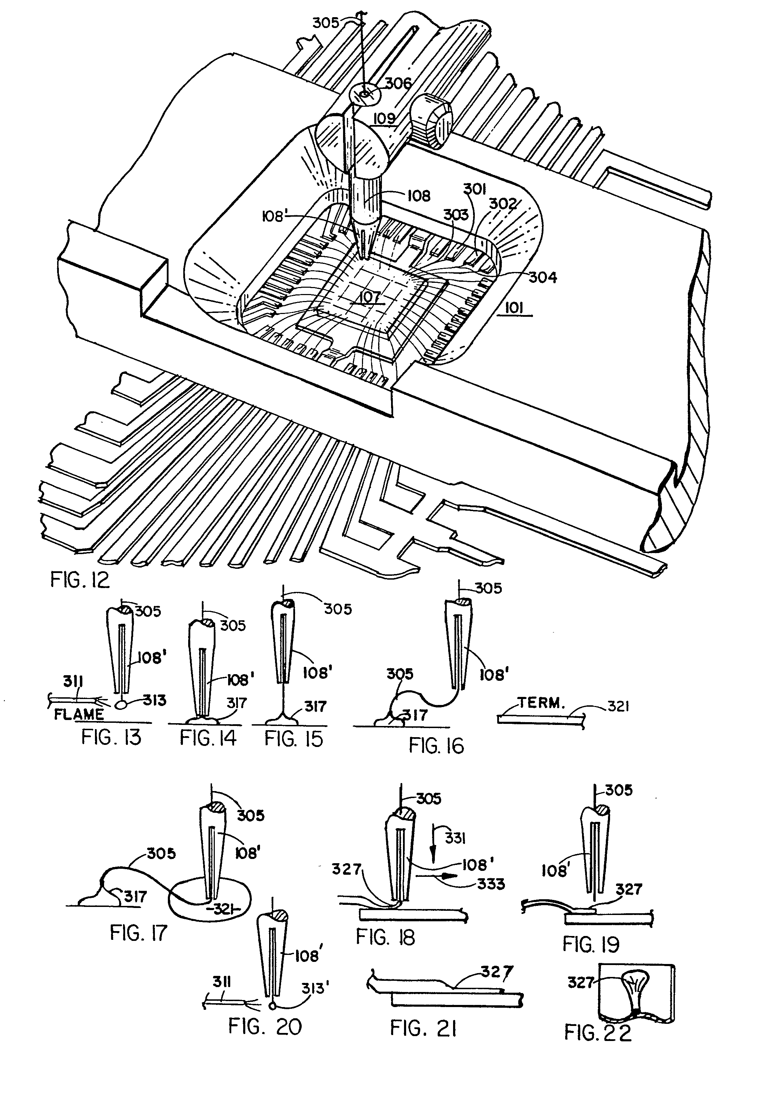

A hydrogen generator apparatus is shown at 51 and provides fuel for the tiny flame (to be described in connection with Figure 13) for forming a ball on the end of the gold wire being utilized as the electrical spanning conductor.

The left hand drawer 61 of the bench type support 13 houses the computer which controls the transducer of the wire bonder to cause it to connect, for example 42 different leads between a die and the connector arms or fingers of the lead frames.

On the right hand side on the front of the bench support 13 are shown the controls, such as 63, for bonding time and the "on-off" knob 65 for the power supply. The heater block temperature control is shown by meter 67.

This view is provided only generally to illustrate the location of the pneumatic wire lifter relative to the wire bonding station.

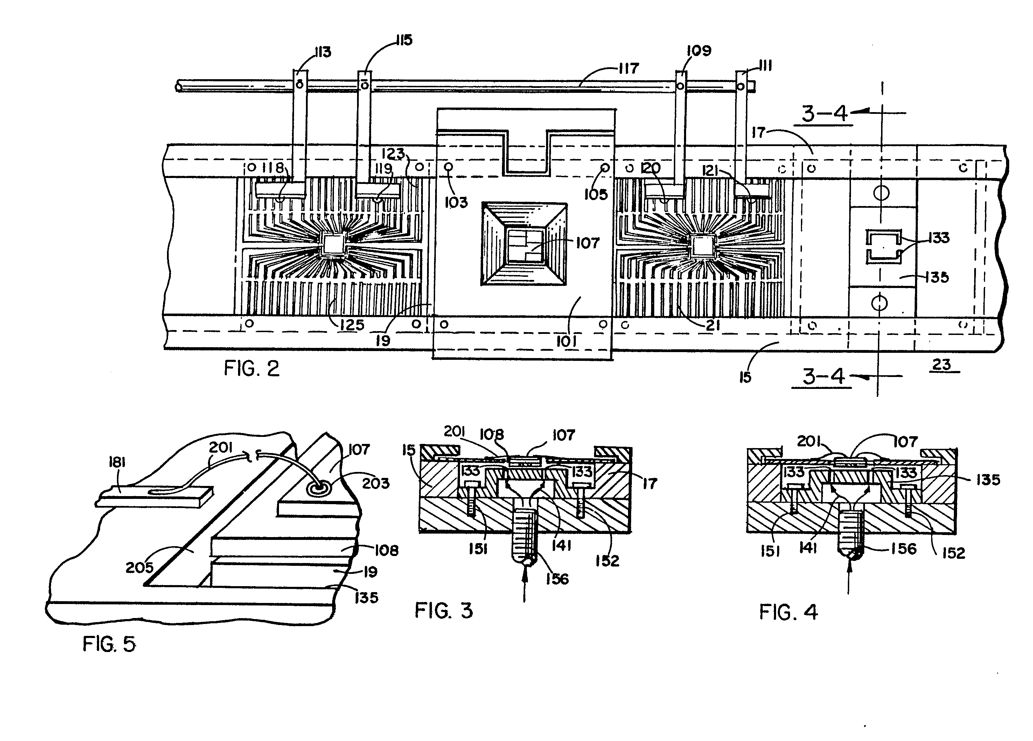

In Figure 2, the rails 15 and 17 defining the pathway of the wire bonder machine 11 are shown from a plan view to illustrate the clamp 101 which holds the lead frame 19 in position during the wire bonding process at the bonding station. Indexing pins, such as 103 and 105 register with holes in the frame to index the die 107 to the stylus 108 connected to transducer 109 (Figure 12) for the wire bonding operation.

The intermittent drive mechanism is shown by the finger carrying arms 109 and 111 to the right, and arms 113 and 115 to the left coupled together by the rigid connector 117. The arms carry depending fingers 118, 119, 120, and 121 for engaging in the slots 123 of the lead frames 125 and 21, as illustrated in Figure 2. These fingers simply are raised and the coupling 117 moved to the left, at which position the fingers are lowered and then the lead frames are advanced to the right until the fingers are again raised for another cycle. During the arrested period, the clamp 101 holds the lead frame 19 for the wire bonding operation, but is removed during the remainder of the cycle.

Since the pneumatic lifting station is in a position corresponding to one or two lead frames away from the clamped position on the downstream side, the lead frame which will be over the pneumatic lifter station 23 will receive an air blast during the arrested motion, i.e., when the bonding operation is taking place at the bonding station.

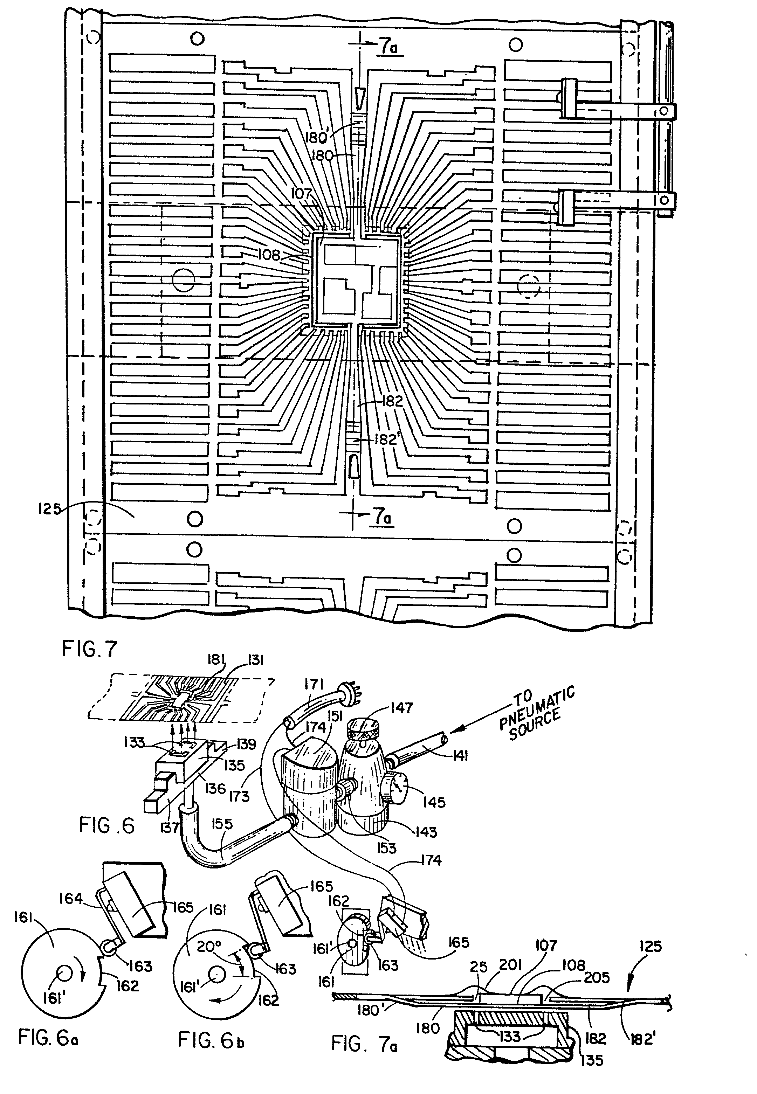

The construction of the pneumatic lifter at station 23 may best be seen from Figure 6 wherein the lead frame 131 is shown advancing along the pathway formed by the rails 15 and 17 in Figure 2, above the orifice 133 of the pneumatic nozzle 135 and manifold 136. The flanges 137 and 139 permit connecting the manifold and orifice structure to the rails 15 and 17. The spacing between the orifice 133 and the pad is of the order of 0.015 inches and there is an additional spacing of 0.015 inches to the gap in the lead frame.

Air or other gas is supplied from a compressor or other source via inlet conduit 141 to pressure regulator 143 having a gauge 145 and an adjustment 147 for permitting the determination of the amount of pressure required for the particular configuration being gas blasted, taking into account the size and length of the wires, configuration of the spacing and orifice and distance therebetween. The exit pressure will be set in the range 20 to 80 psi and the supply pressure will be approximately 125 psi. A solenoid valve 151 receives the gas pressure from pressure regulator 143 via conduit 153 and delivers it as a blast via conduit 155 to the manifold directing structure 136 including nozzle 135 and orifice 133.

The timing control for the gas blast is achieved through the use of cam 161 and follower 163 carried by spring arm 164 for microswitch 165. In Figure 6, the electrical cord 171 is adapted to be plugged into a source of power with one lead 173 extending directly to microswitch 165 and the other lead 174 extending to the solenoid of solenoid valve 151. Hence, when follower 163 rides in the cutaway portion 162 of cam 161 it may be seen that microswitch 165 is actuated to open the solenoid valve 151 for approximately 20° of a revolution of cam 161. This is sufficient time for the release of pressure via orifice 133 to bow the wires upwardly and eliminate short circuits. The cam shaft 161' is mechanically coupled to reciprocating bar 117 of Figure 2, thereby providing for synchronization.

In the Shinkawa Ltd. high speed thermal compression ball bonder, the time for revolution of cam 161 is 1.1 seconds. The 20° cutout 162 represents a dwell time of about six hundredths of a second. The pressure is set by regulator 143 to that the gas blast is sufficient to raise the wires without fracturing the same, and the orifice 133 is sufficiently close to the lead frame 131 as substantially to preclude air from striking the fingers of the connectors 181 and bending them upwardly or to displace the pad and die. Time delay circuitry may be readily substituted for the cam 161, e.g., a relay may be used.

Figures 3, 4, 5, and 7a show the details of the fine gauge wires to gas relationship. For example, in Figure 5 the gold wire 201 is shown bonded between the finger or tip of an electrical conductor 181 and the aluminum terminal 203 of chip or die 107. The wire bridges the gap 205 between the fingertips of the conductors 181 and the terminal 203 of die or chip 107. Wire 201 is shown bowed upwardly, as it appears after it has been through gas lifter station 23. The orifice 133 of Figures 2, 3, and 4 conforms to the gap 205 of Figure 3 so that air may follow the path of the arrows 141 and exit the manifold nozzle 135 via the orifice 133.

Confinement of the air or gas blast to the gap 205 precludes bending of the fingers of conductors 181 or of the pad 108 supporting the die or chip 107.

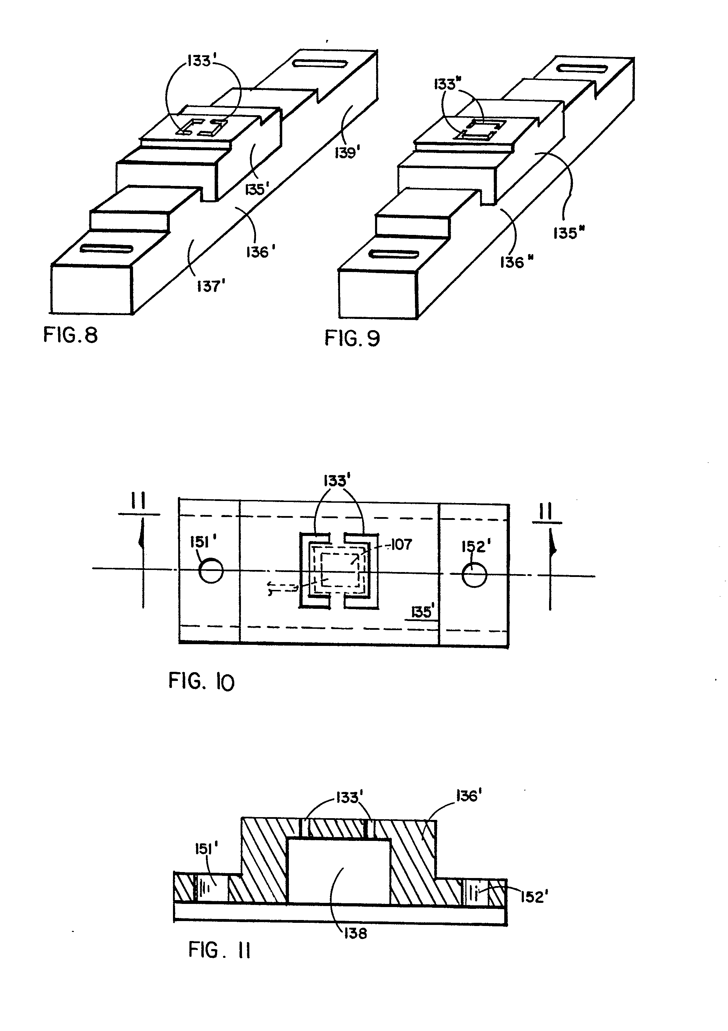

The reason for the screws 151 and 152 in Figure 3 is to permit removal of the nozzle 135 to switch nozzles to change the configuration of the orifice 133. Figures 8 and 9 show two different types of orifices, 133' and 133".

Figures 7, 7a, 8, 9, 10, and 11 show details of the nozzle and manifold of the lifter relative to the lead frame 125. It will be noted that the pad 108 is supported by two lead frame arms 180 and 182 (Figure 7) extending diametrically opposite to each other, and in the case of the lead frame 125 of Figure 7 they extend in the direction of travel through the wire bonding machine. Each of these arms is bent downwardly as shown at 180' and 182' to lower the pad 108 slightly beneath the place of the lead frame 125. This is best seen in Figure 7a. Since the pad 108 is a portion of the lead frame as stamped out, it represents the closest proximity of the lead frame to the upper surface of nozzle 135. This distance is typically 0.015 inches with the spacing being for example 0.030 inches to the place of the lead frame 125 or to the gap 205, as is also shown in Figure 5. A pair of fine gauge wires are shown having been raised above the pad 108 by blasts via nozzle orifice 133, the left hand wire being identified at 201. It will be noted that the nozzle 135 has a relatively large thickness wherein the orifice 133 is formed. This thickness is like a rifle barrel in blasting the air across the 0.030 inch air gap 205 to raise the wire 201. The wire diameter may typically be in the range 0.001 to 0.002 inches.

Many configurations of lead frames exist in today's conventional manufacturing processes, and it is customary for the number of lead wires to vary, the size and shape of the pad to vary and the gap dimensions to change. Also, the wire gauge and length of wire may be different and hence the reason for the retulator 143 in the lifter of Figure 6. It has been found that an input pressure to conduit 141 of the order of 125 pounds per square inch is sufficient to provide an output at conduit 153 variable between 20 and 40 pounds per square inch for accomodating most nozzles contemplated for use herein.

Accordingly, Figures 8 and 9 illustrate two different nozzles 135' and 135", including respectively, orifices 133' and 133". It will be immediately apparent that they are oriented orothogonally such that the supporting arms for the lead frame associated with nozzle 135' of Figure 8 would extend in a vertical direction relative to the horizontal direction of the supporting arms for nozzle 135" of Figure 9. Usually, the manifolds 136' and 136" may be identical and merely the nozzles 135' and 135" interchangeable with other nozzles.

In the plan view of Figure 10 the mounting holes 151' and 152' are visible in the flanges of nozzle 135'.

In Figure 11, the manifold chamber 138 is shown in communication with the orifice 133' and it will be noted from Figures 3, 4, and 6 that the manifold chamber 138 receives its air or gas supply via conduits 155 and 156.

The preferred structure has now been described, but it should be noted that in Figure 6 the lifter, per se, may be defined simply by removing cam 161 and operating follower 163 in the nature of an on-off button. Thus, it may be appreciated that the pneumatic lifter, per se, comprises the input air conduit 141, adjustable regulator 143, solenoid valve 151, tubular conduit 155, and nozzle 135 with manifold 136. The timing arrangements simply comprises the switch 165 which may be manually operated for use at an inspection station, for example, where the bonded lead frames may be individually inspected and corrected if sagging gold wires are found. Similarly, the pneumatic lifter could comprise a special machine having its principal use for pneumatic wire lifting or it could be used to perform minimum wire pull tests by adjusting gas blast pressure high enough to generate minimum pull test force on the wire.

Figures 12 through 22 will be used in the ensuing description of typical operation of the preferred embodiment incorporated in a wire bonding machine. Starting with a series of lead frames attached together, such as five or six frames generally in strip form, as shown by the frames 125, 19, and 21 in Figure 2, the first frame in the strip is engaged by the reciprocating pins 118 and 119 and pulled to the right (Figure 2) until the first frame is beneath clamp 101. A detailed view of the structure at this point is shown in Figure 12 wherein clamp 101 is securely holding the cantilever finger connectors, such as 301 and 302, to receive the fine gold wires 303 and 304 through stylus 108 guided by transducer 109; the gold wire 305 coming from a supply and entering orifice 306 of transducer 109. This is a standard or conventional step in bonding the wire 305 between the conductor fingers, such as 301 and 302 and aluminum terminals on the die or chip 107.

It is necessary to appreciate the intricacy of this operation in order to understand the dire need for the subject invention because, prior to the invention, in running 40 wire lead frames, i.e., 40 terminals, a typical 248 piece sample would produce 48 pieces requiring manual reworking. This means that at a separate station, and through a microscope having a power capability of 35,000 magnification, or thereabouts, a person would observe any sagging or shorting wires and pnysically lift those with tweezers or other tool to endeavor to correct the faulty pieces. The largest cost here are the manual operations necessary for correction, but even so, five to ten percent of the pieces are totally lost at this point. Machines are capable of running 20,000 pieces a week and a typical assembly plant may include 40 to 50 machines.

After installation of the pneumatic lifter, a 496 piece sample was taken and only three pieces were allotted to rework. Hence, the tremendous value of the subject invention. The computer of drawer 61 of supporting table 13 (Figure 1) controls the sequencing of the stylus capillar 108' throughout Figures 13 through 20 to develop the bonds, cut the wire, and advance to the succeeding bonding positions. In Figure 13 flame 311 is shown melting wire 305 to form a ball 313 on the lower end thereof. Flame 311 is derived from the hydrogen generator 51 located on bench 13 in Figure 1.

In Figure 14 the stylus capillar 108' has moved down to compress the ball 313 into the flattened semi-circular bond 317, and the stylus capillar 108' is moving up to advance the wire 305 across the air gap to bond it to one of the finger connectors. This is shown in Figure 17 wherein the terminal 321, usually of aluminum, is carried by the die or chip 107 (Figure 12).

In Figure 18 the bond has been made at end 327 of wire 305 and the movement of capillar 108' is downwardly, as shown by the arrow 331, and to the right, as shown by the arrow 333, to sever the wire and leave the bonded end 327 shown in Figure 19 as the capillar and wire 305 are raised.

The sequence begins anew with Figure 20 wherein the flame 311 forms a new ball 313'.

Figure 21 shows the bonded end 327 in side elevation and Figure 22 shows the bonded 327 in top plan view as the capillar 108' has formed it in the operation of Figure 18.

It is not feasible to repair any of these bonds manually because it is enough of a chore just to lift the sagging wires to avoid short circuits. When it is appreciated that the entire operation of Figures 13 through 20 is carried out by the machine in six hundredths

0063170

of a second, it will be realized that any manual operation is costly.

After all 40 or 42 terminals or other number of terminals have been bonded and connected to their proper positions, making a total of some 80 to 84 bonds, the strip of lead frames is advanced and this bonded lead frame may reach the lifting station 23 or it may require a further advancement to reach the lifting station 23 of Figure 2 (as pictured). It is the fingers 118, 119, and 120, 121 operating from the reciprocating bar 117 which advance the strip of lead frames.

Reciprocating bar 117 is mechanically interconnected with shaft 161' (Figure 6a, 6b, and 7a) for the 1.1 second cycle of the machine. As cam 161 rotates clockwise, the normally open microswitch 165 is closed while its spring arm 164 follower 163 is in recess 162. This dwell portion occupies 20° of a revolution of cam 161 and consequently during the 0.06 seconds arrested motion, the solenoid valve 151 is actuated to fire a gas blast through orifice 133 to lift or bow the gold wires, such as 201, from the position shown in Figure 3 to the position shown in Figure 4.

The process is automatically repeated and the strip of lead frames advanced until dispensed into a carrier for removal to inspection or potting stations. The machines may be continuously run 24 hours a day providing they are fed with strips to achieve the high outputs mentioned.

While other modifications of the inventions disclosed herein will occur to those skilled in the art from a reading of the detailed description hereof, nevertheless the inventions are intended to be defined by the scope of the appended claims wherein:

The invention may be summarized as follows:

1. In combination with a wire bonder machine which intermittently advances lead frames along a pathway therethrough for MOS plastic packaging and bonds fine gauge wires between terminals of a die fixed to a pad carried by each lead frame and spaced apart lead frame fingers of connectors distributed about the pad periphery and spaced therefrom across a gap, a pneumatic wire lifter for lifting the wires out of contact with the pad comprising, in combination:

means for developing gas pressure for gas blasts;

pneumatic directing means disposed adjacent a pathway for said lead frames travelling through said machine at a location downstream of the wire bonding station for directing gas blasts at said wires to raise them above said pad;

said directing means confining the gas blasts generally externally of and along the pad periphery in the gap region to bend the wires upwardly away from the pad; and,

timing means operating in synchonism with said advancing of lead frames for initiating the gas blasts during the dwell intervals of said frames.

2. The invention of Item 1, wherein:

said directing means comprises a gas orifice configured to said gap for substantially precluding gas blasts against said pad or fingers.

3. The invention of Item 2, wherein:

said means for developing pressure comprises an adjustable pressure regulator for establishing the pressure of said blasts relative to the gap dimensions, wire dimensions, and spacing of the orifice from the wires.

4. The invention of Item 3, wherein:

said timing means comprises an electrically operable valve means connected between the directing means and the pressure regulator for releasing gas to the directing means.

5. The invention of Item 4, wherein:

said timing means further comprises a rotary timing means synchronized to the intermittent feed, and means responsive to said rotary means for actuating said valve for a predetermined time interval during arrested motion of the lead frames.

6. The invention of Item 5, wherein:

said valve means comprises a solenoid, said rotary timing means is a cam, and said means responsive thereto is a follower for switching electrical current to the solenoid for said valve.

7. The invention of Item 6, wherein:

said directing means comprise a manifold for distributing air to said orifice and a frame for attachment to said machine beneath the pathway, and a nozzle carrying said orifice in proximity to said lead frames.

8. The invention of Item 7, wherein:

said nozzle is interchangeable with other nozzles having different orifice configurations to match the gaps of different lead frames;

the spacing between the orifices and the gap is of the order of 0.030 inches, the available pressure is selectible in the range 20-80 psi, and the wire diameter for 24K gold wire is of the order of 0.0009 to 0.002 inches.

9. A pneumatic wire lifter for bowing one or more wires attached at each end comprising, in combination:

means for developing gas pressure for controlled gas blasts;

pneumatic gas directing means for directing gas blasts at said one or·more wires from beneath to raise them intermediate their ends; and,

means for controlling the pressure and duration of said blasts with said directing means confining the gas discharge to the region of said one or more wires.

10. The lifter of Item 9, wherein:

said means for controlling comprises a pulsing circuit and a solenoid valve responsive thereto for permitting the gas flow from the means for developing to the directing means as a controlled blast.

11. The method of pneumatically lifting one or more wires intermediate their attached ends comprising, the steps of:

developing gas pressure for controlled gas blasts;

providing directing means extending adjacent to said one or more wires for directing the controlled air blasts against the one or more wires; and,

controlling the pressure and duration of said blasts thereby to control the lifting without fracturing a wire.

12. The method of Item 11, wherein:

said directing means confine the air blasts to the wires intermediate their attached ends without disturbing the means to which they are attached.

WHAT IS CLAIMED IS:

1.   In combination with a wire bonder machine which intermittently advances lead frames along a pathway therethrough for MOS plastic packaging and bonds fine gauge wires between terminals of a die fixed to a pad carried by each lead frame and spaced apart lead frame fingers of connectors distributed about the pad periphery and spaced therefrom across a gap, a pneumatic wire lifter for lifting the wires out of contact with the pad comprising, in combination:
   means for developing gas pressure for gas blasts;
   pneumatic directing means disposed adjacent a pathway for said lead frames travelling through said machine at a location downstream of the wire bonding station for directing gas blasts at said wires to raise them above said pad;
   said directing means confining the gas blasts generally externally of and along the pad periphery in the gap region to bend the wires upwardly away from the pad; and,
   timing means operating in synchonism with said advancing of lead frames for initiating the gas blasts during the dwell intervals of said frames.

2.   The invention of Claim 1, wherein:
   said directing means comprises a gas orifice configured to said gap for substantially precluding gas blasts against said pad or fingers.

3.   The invention of Claim 2, wherein:
   said means for developing pressure comprises an adjustable pressure regulator for establishing the pressure of said blasts relative to the gap dimensions, wire dimensions, and spacing of the orifice from the wires.

4. The invention of Claim 3, wherein:

said timing means comprises an electrically operable valve means connected between the directing means and the pressure regulator for releasing gas to the directing means.

5. The invention of Claim 4, wherein:

said timing means further comprises a rotary timing means synchronized to the intermittent feed, and means responsive to said rotary means for actuating said valve for a predetermined time interval during arrested motion of the lead frames.

6. The invention of Claim 5, wherein:

said valve means comprises a solenoid, said rotary timing means is a cam, and said means responsive thereto is a follower for switching electrical current to the solenoid for said valve.

7. The invention of Claim 6, wherein:

said directing means comprise a manifold for distributing air to said orifice and a frame for attachment to said machine beneath the pathway, and a nozzle carrying said orifice in proximity to said lead frames.

8. The invention of Claim 7, wherein:

said nozzle is interchangeable with other nozzles having different orifice configurations to match the gaps of different lead frames;

the spacing between the orifices and the gap is of the order of 0.030 inches, the available pressure is selectible in the range 20-80 psi, and the wire diameter for 24K gold wire is of the order of 0.0009 to 0.002 inches.

9.  A pneumatic wire lifter for bowing one or more wires attached at each end comprising, in combination:.

means for developing gas pressure for controlled gas blasts;

pneumatic gas directing means for directing gas blasts at said one or more wires from beneath to raise them intermediate their ends; and,

means for controlling the pressure and duration of said blasts with said directing means confining the gas discharge to the region of said one or more wires.

10.  The lifter of Claim 9, wherein:

said means for controlling comprises a pulsing circuit and a solenoid valve responsive thereto for permitting the gas flow from the means for developing to the directing means as a controlled blast.

FIG. 1

FIG. 2

FIG. 3

FIG. 4

FIG. 5

FIG. 7

FIG. 6

FIG. 6a

FIG. 6b

FIG. 7a

FIG.8

FIG.9

FIG. 10

FIG. 11

FIG. 12

FIG. 13 FIG. 14 FIG. 15 FIG. 16

FIG. 17 FIG. 18 FIG. 19

FIG. 20 FIG. 21 FIG. 22